# EUROPEAN PATENT APPLICATION

(11) **EP 2 149 401 A2**
(43) Date of publication of application: **03.02.2010**
(21) Application number: 09165827.8
(22) Date of filing: 17.07.2009
(51) Int. Cl.: B05C 19/04, H01L 31/18

(54) **System and method for distributing a fluidic mass**

(30) Priority: 28.07.2008 US 180779
(71) Applicant: General Electric Company, Schenectady, NY 12345 (US)
(72) Inventor: Pisklak, Stephen George, Hockessin, DE 19707 (US); Reed, Mason Jacob, Perry Hall, MD 21128 (US); Colgan, Christopher John, Lincoln University, PA 19352 (US)
(74) Representative: Bedford, Grant Richard

(57) **Abstract**

Disclosed herein is a system (10) for distributing a fluidic mass (18). The system (10) includes, a receptacle (14), receptive of the fluidic mass (18) to be distributed, an opening (50), fluidically connected to the receptacle (14), a surface (62) in operable communication with the opening (50) and receptive of a distribution of the fluidic mass (18) from the receptacle (14) such that a rate of the distribution of the fluidic mass (18) is determined by a speed of the surface (62) relative to the opening (50), and a substratum (102). The substratum (102) is positioned below the surface (62) and movable relative to the surface (62), and movement of the substratum (102) relative to the surface (62) controls a thickness (106) of a base layer (110) of the fluidic mass (18) formed on the substratum (102).

## Description

The disclosed invention relates generally to an apparatus and method for distributing a fluidic mass or powder. More specifically, the invention relates to control of the distribution rate of the fluidic mass.

Many industries include processing steps of distributing a fluidic mass in a thin even layer onto a moving surface. The manufacture of solar cells, for rooftop generation of electricity, is an example of one such industry. The manufacture of solar cells includes melting and recrystallizing layers of silicon powder. The powder is often placed onto trays, also known as setter plates that travel through a furnace that has a controlled atmosphere to make such things as silicon wafers for solar cells.

The commercial success of a solar cell is strongly influenced by the efficiency of the solar cell. The efficiency, a ratio of how much electrical energy is produced relative to the amount of solar energy that is available, is strongly dependent upon the dimensional characteristics of the silicon wafers that make up the solar cell. The overall thickness and the uniformity of the thickness are two such dimensional characteristics.

A strong correlation has been found between the thickness and the uniformity of the thickness of a finished silicon wafer, and the silicon powder layer from which it was manufactured. One current method utilized to control the thickness of the powder layer includes a blade, positioned above the moving setter plates, by an amount equal to the desired thickness. The blade scrapes away any powder that is above the desired thickness as the setter plates move under the blade. This blade scraping method, however, is sensitive to bends and nonuniformities in the setter plates themselves.

Accordingly, there is a need in the art for improvements in the control of the thickness and uniformity of distributed fluidic mass layers.

Disclosed herein is a system for distributing a fluidic mass. The system includes, a receptacle, receptive of the fluidic mass to be distributed, an opening, fluidically connected to the receptacle, a surface in operable communication with the opening and receptive of a distribution of the fluidic mass from the receptacle such that a rate of the distribution of the fluidic mass is determined by a speed of the surface relative to the opening, and a substratum. The substratum is positioned below the surface and movable relative to the surface, and movement of the substratum relative to the surface controls a thickness of a base layer of the fluidic mass formed on the substratum.

Further disclosed herein is a method of distributing a fluidic mass. The method includes, disposing the fluidic mass in a receptacle with an opening, distributing the fluidic mass to a surface downstream of the opening, moving the surface thereby removing the fluidic mass from downstream of the opening to allow additional fluidic mass to distribute through the opening, controlling a rate of the distribution of the fluidic mass by a speed of the surface, and positioning the surface relative to the opening to prevent the fluidic mass from flowing through the opening when the surface is stationary.

The following descriptions should not be considered limiting in any way. With reference to the accompanying drawings, like elements are numbered alike:
FIG. 1 depicts a perspective view of a fluidic mass distribution system disclosed herein;
FIG. 2 depicts a cross sectional view of the system of FIG. 1;
FIG. 3 depicts a partial cross sectional view of FIG. 2 at a higher magnification and with the addition of a setter plate;
FIG. 4 depicts an exploded view of a rotor seal assembly disclosed herein;
FIG. 5 depicts a partial perspective view of an alternate embodiment of the fluidic mass distribution system disclosed herein; and
FIG. 6 depicts a partial cross sectional view of the system of FIG. 5.

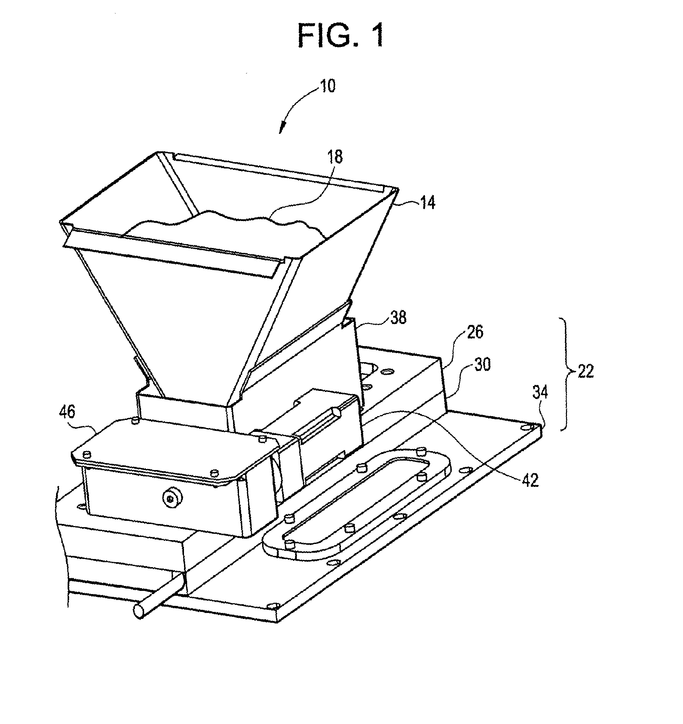

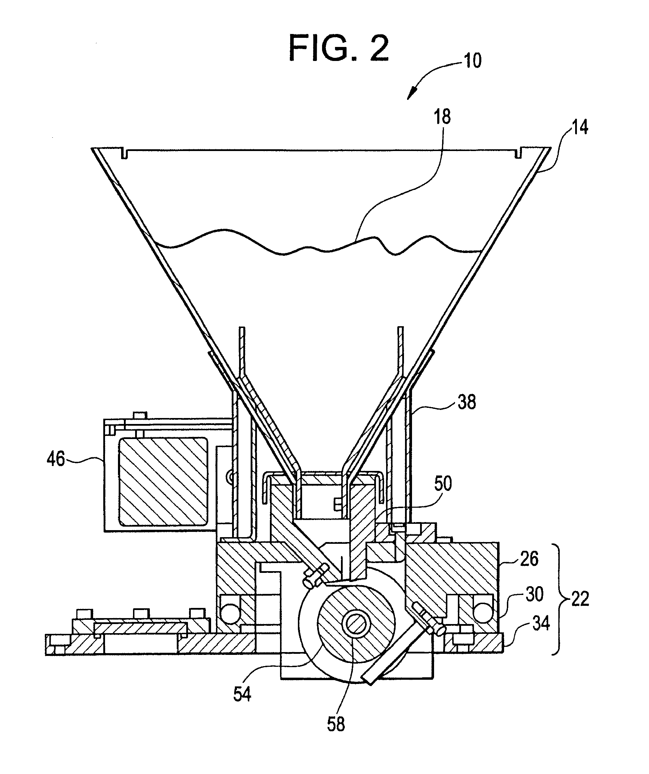

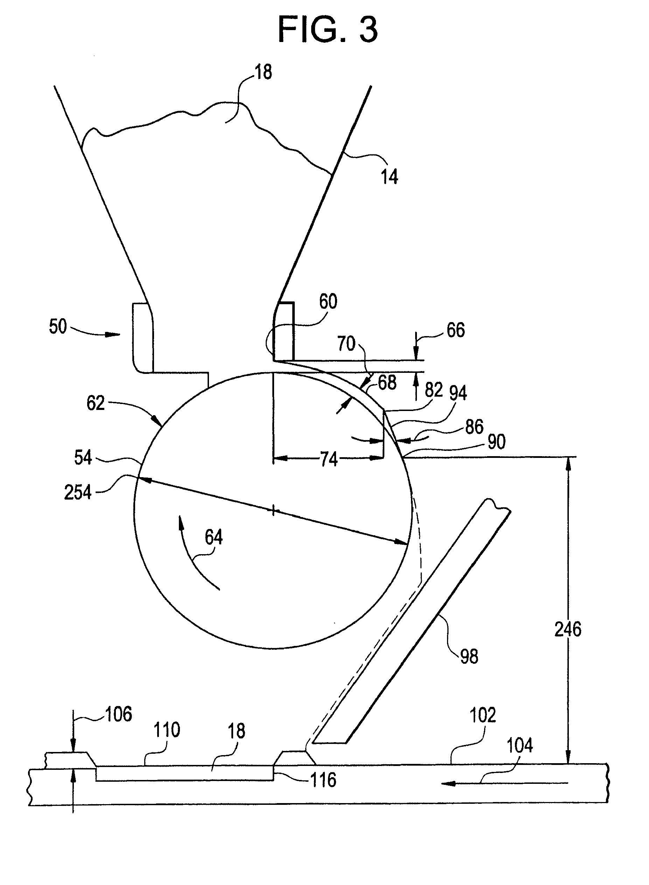

Referring to FIG. 1, a perspective view of a fluidic mass distribution system is shown generally at 10. A receptacle 14 (also referred to herein as a hopper), stores a fluidic mass 18 prior to distribution. The fluidic mass 18 may be a powder or other substance that meets the conditions disclosed in this specification. The hopper 14 is structurally supported above a base 22, by a bracket 38, which is also attached to the base 22. The base 22 is constructed of three plates together and identified in FIG. 1 as upper plate 26, middle plate 30 and lower plate 34. In one embodiment, and as illustrated, the plates are fastened together via bolts. It will be understood that other forms of fastening such as clips, adhesives, and clamps among others may also be employed. A motor 42 and gear box 46 are attached to the base 22 and operably communicate with the fluidic mass 18 after it exits the hopper 14 as will be described in detail with reference to Figures 2 and 3.

Referring to Figures 2 and 3, the hopper 14 is fluidically connected to an opening 50 (also referred to herein as an outlet), at the lower end of the hopper 14, thereby allowing gravity to force the fluidic mass 18 therethrough. A rotor 54, with a shaft 58, is positioned below the outlet 50. The rotor 54, which is cylindrically shaped, and its shaft 58 are rotatably attached to the base 22. A belt, gear train or chain (not shown) rotationally couple the shaft 58 with the motor 42 through the gear box 46, thereby allowing rotational control of the motor 42 to also permit rotational control of the rotor 54. Rotational control of the rotor 54 is key to controlling the distribution rate of the fluidic mass 18 as will be described below in greater detail.

A blade 60 portion of the outlet 50 extends downward from the outlet 50 towards a surface 62 of the rotor 54, and is parallel to the surface 62. The space between the blade 60 and the surface 62 forms a gap 66 through which the fluidic mass 18 will travel in response to clockwise rotation depicted by arrow 64 (as viewed in the direction of Figures 2 and 3) of the rotor 54. A thickness 70 of an interim fluidic mass layer 68 on the surface 62 of the rotor 54 is determined by the size of the gap 66 and is substantially equal to the size of the gap 66. Thus, rotation of the rotor 54 removes the fluidic mass 18 from below the outlet 50, allowing additional fluidic mass 18 to move from the hopper 14 through the outlet 50 and onto the surface 62. A knurl may also be applied to the surface 62 to enhance removal of the fluidic mass 18 in response to rotation of the rotor 54. Since the thickness 70 of the interim layer 68 is fixed by the size of the gap 66, the distribution rate of the fluidic mass 18 can be accurately controlled through control of the rotational speed of the rotor 54.

The gap 66 is also sized such that head pressure in the hopper 14 is not able to force the fluidic mass 18 through the gap 66 when the rotor 54 is not rotating. This allows for complete stoppage of distribution of the fluidic mass 18 by simply stopping the rotation of the rotor 54. In order to assure that this condition is maintained, the blade 60 should be placed a minimum horizontal distance 74 from a point 82 where gravity causes the fluidic mass 18 to fall under its own weight. The point 82 can be found by first determining the angle of repose 86 for the specific fluidic mass 18 being distributed. Once the angle of repose 86 is determined, draw a tangency line 94 at this angle of repose 86 from the surface 62 until it intersects with the interim layer 68. Once the location of point 82 is established, the horizontal distance 74 from the point 82 to the blade 60 can be set, thereby preventing the fluidic mass 18 from distributing when the rotor 54 is not rotating.

During distribution of the fluidic mass 18, the rotation of the rotor 54 causes the fluidic mass 18, as it reaches the point 82, to fall under its own weight, at the angle of repose 86 and off the tangency point 90 and onto a ramp 98. The ramp 98, positioned partially below the rotor 54, guides the fluidic mass 18 to substratums 102 (also referred to here as setter plates) also positioned below the rotor 54. The setter plates 102 are moved in a direction of arrow 104, relative to the rotor 54, thereby allowing a thickness 106 of a base layer 110 of the fluidic mass 18 to be formed upon the setter plates 102. The aforementioned structure allows for the control of the thickness 106 by controlling the speed of movement of the setter plates 102 in relation to the rotor 54. It should be noted that the ramp 98 could also be omitted thereby letting the fluidic mass 18 fall directly from the surface 62 to the setter plates 102.

Additionally, the setter plates 102 may include recesses 116 formed therein for shaping the base layer 110 of the fluidic mass 18 into shapes of a wafer, for example. Such shapes may be useful for manufacturing silicon wafers for usage in solar cells where the wafers are made from silicon powder that is melted and re-crystallized to form the wafers.

In some applications, such as for making silicon wafers for example, it may be desirable to attach the fluidic mass distribution system 10 directly to an atmosphere controlled furnace or kiln (not shown). Such an attachment may provide for the silicon powder 18, distributed from the fluidic mass distribution system 10, to be exposed to only the furnace-controlled atmosphere until after the silicon has recrystallized into a wafer. Such a construction may be achieved by sealably attaching the lower plate 34, of the base 22, directly to a wall of the furnace (not shown). This construction creates a leak path, for the atmosphere of the furnace, through the outlet 50 and up through the hopper 14, during times when the hopper 14 and outlet 50 are not filled with fluidic mass 18. Stated another way, the fluidic mass 18, in the outlet 50 and in the hopper 14, forms a seal to prevent gases in the controlled atmosphere of the furnace from escaping. It is therefore an advantage of an embodiment of the invention to be able to change the distribution rate of the fluidic mass 18, by simply changing the rotational speed of the rotor 54, without having to empty the hopper 14, of fluidic mass 18, in order to make an adjustment to the rotor 54 or the outlet 50. It is a further advantage of an embodiment to be able to change the thickness 106 of the base layer 110 of fluidic mass 18, by changing the rotational speed of the rotor 54, without having to change the speed of the setter plates 102 relative to the rotor 54.

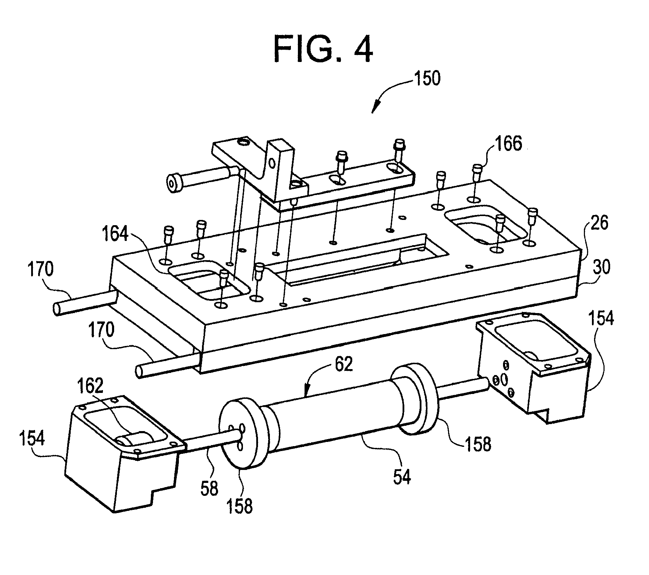

Referring to FIG. 4, an exploded view of a rotor seal assembly 150 shows the rotor 54 and associated sealing components. The rotor shaft 58 extends beyond the surface 62, and beyond a pair of shoulders 158, located at opposite ends of the surface 62 of the rotor 54 and into bearing wells 154. The shoulders 158 prevent the fluidic mass 18 that is being distributed from flaring beyond the edges of the setter plates 102. The bearing wells 154 house carbon bearings (not shown) that rotationally support the shaft 58 while sealing to the shaft 58 to prevent gases in the furnace from escaping and to prevent the abrasive fluidic mass from reaching the components housed within the wells 154. A pulley 162, rotationally fixed to the shaft 58, resides within one of the bearing wells 154 and receives a drive belt (not shown) that extends from the gear box 46 (FIG. 1) through hole 164 in the upper plate 26 and middle plate 30. The motor 42 drives the rotor 54 through the gear box 46, drive belt, and pulley 162, just described.

The bearing wells 154 are sealably attached to the underside of the middle plate 30, with bolts 166, and extend down into the atmosphere of the furnace. The middle plate 30 is sealably attached to the lower plate 34 that is sealably attached to the furnace housing (not shown). The bearing wells 154, the bearings, the pulley 162 and the belt are all heated by the furnace and need to be cooled. Liquid cooling is provided through channels 170 that are fluidically coupled to cooling channel (not shown) within the middle plate 30. Heat conduction through the bearing wells 154, which are bolted to the middle plate 30, transfer heat from the components within the bearing wells 154 to the cooling fluid. In alternate embodiments, however, the opening 50 may be outside of the furnace atmosphere where the temperatures are much lower. Such an embodiment will be described below.

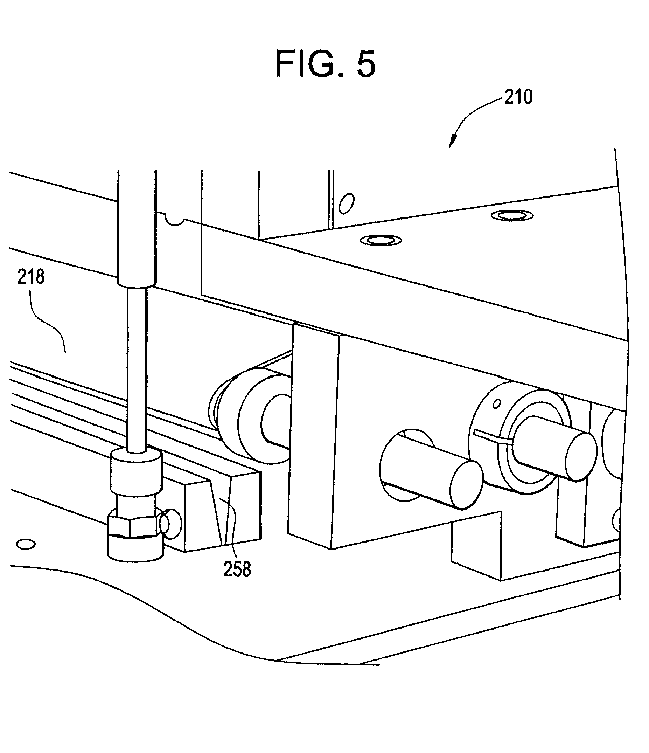

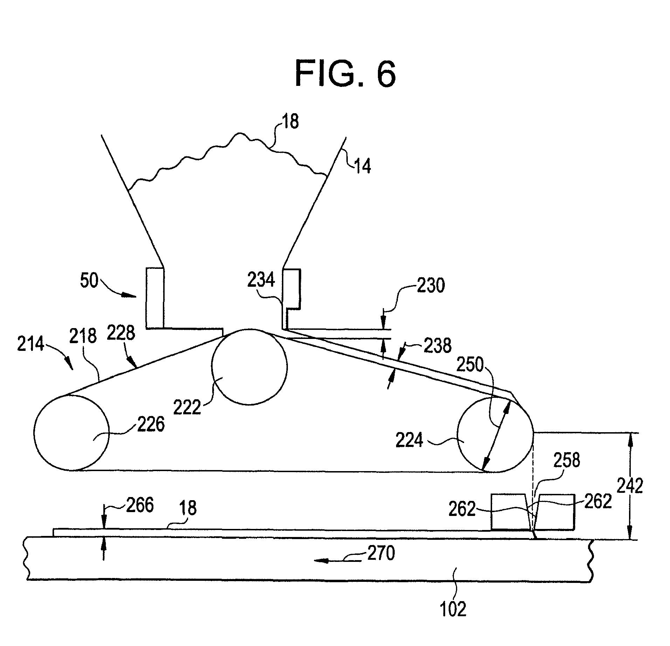

Referring to Figures 5 and 6, an alternate embodiment of the fluidic mass distribution system 210 is illustrated. The system 210 is similar to the system 10 in that the fluidic mass 18 is stored in the hopper 14 that is positioned above the movable setter plate 102. A main difference between the systems 10 and 210, besides the fact that the opening 50 is outside of the furnace, is that in the system 210 the rotor 54 has been replaced with a belt and roller system 214. The belt and roller system 214 includes, a belt 218, and at least two rollers, or cylinders, with three rollers 222, 224, 226 being illustrated in this embodiment. Although the belt is positioned outside of the furnace, heat from the setter plate 102 can still raise the temperature of the belt 218 significantly. Materials that can handle high temperatures are therefore recommended for the belt such as, woven Kevlar (Note: Kevlar is a registered trademark of the Dupont Corporation) coated with silicon, for example. One or more of the rollers 222, 224, 226 are rotationally driven by a belt, gear train or chain (not shown) rotationally couple with the motor 42 through the gear box 46, for example, thereby allowing rotational control of the belt 218 with the motor 42. The rollers 222, 224, 226 and belt 218 rotate in a clockwise direction as viewed in FIG. 6 (counterclockwise as viewed in FIG. 5). One or more of the rollers 222, 224 and 226 may be crowned such that a radial dimension of the crowned roller(s) is greater at a central portion and tapers to a lesser radial dimension near the ends. Such crowning causes the belt 218 to remain centered relative to the rollers 222, 224, 226. It may be desirable for the crowning to be only on the roller 226 since crowning either of the rollers 222 or 224 could have a detrimental effect on the fluidic mass 18 distribution as will become more clear by the detailed description of control of the fluidic mass 18 distribution below.

The belt 218 is positioned immediately downstream from the opening 50 (which in this embodiment is below the opening 50) such that a surface 228 of the belt 218 is a dimension 230 from a blade 234 of the opening 50 that controls a thickness 238 of the fluidic mass 18 on the surface 228. The dimension 230 is set such that head pressure of the fluidic mass 18 in the hopper 14 does not force the fluidic mass 18 through the dimension 230 when the belt 218 stationary. As such, distribution of the fluidic mass 18 from the hopper 14 can be completely stopped by halting movement of the belt 218. Additionally, a rate of distribution of the fluidic mass 18 from the hopper 14 is controlled by the speed of the belt 218, which in this embodiment is controlled by the speed of the motor 42. The use of the belt 218 allows the fluidic mass 18 to be at a smaller dimension 242 relative to the setter plate 102 when the fluidic mass 18 drops from the surface 228 when compared to the dimension 246 (FIG. 3) relative to the setter plate 102 when the fluidic mass 18 drops from the surface 62. This is due to a diameter 250 of the roller 224 being smaller than a diameter 254 of the rotor 54 since a smallest possible size of the dimensions 242, 246 are in part determined by the diameters 250, 254 respectively. Decreasing a size of the dimensions 242, 246 can be helpful in decreasing spread of the fluidic mass 18 (and thus improving control of the deposition) by decreasing the height and consequentially the speed of the fluidic mass 18 as it lands on the setter plate 102.

Additional control of the spreading of the fluidic mass 18 onto the surface 228 can be provided through use of an optional trough 258 formed by two angled surfaces 262 positioned along the dimension 242. The trough 258 will slow the fluidic mass 18 further before it reaches the setter plate 102. The trough 258 also helps to smooth out any non-uniform rate of distribution that may occur as the fluidic mass 18 drops in waves from the surface 228.

In regards to crowning of the rollers 222, 224, 226, as mentioned above, a crowning of the roller 222 would be undesirable since the dimension 230 would vary across a width of the belt 218 causing a non-uniform distribution of fluidic mass 18 across the width of the belt 218. Crowning of the roller 224 would also be undesirable since crowning of roller 224 would cause a variation in the dimension 242 across the width of the belt 218, thereby negatively affecting control of the spread of the fluidic mass 18 on the setter plates 102.

A thickness 266 of the fluidic mass 18 on the setter plate 102 is controllable by the rate of speed of the setter plates 102, in a direction of arrow 270 in the view of FIG. 6, relative to the belt 218. The thickness 266 can, therefore, be controlled and changed by one of two ways. First, by the speed of the setter plate 102 and second, by the speed of the belt 218. Each of these speeds can be controlled separately from one another and each can be changed without stopping distribution of the fluidic mass 18 from the fluidic mass distribution system 210.

Some embodiments of the inventions may include the following advantages:
controlling a rate of fluidic mass distribution through control of speed of a surface, controlling a layer thickness of the fluidic mass on a substratum through control of the surface speed or the substratum speed, changing a thickness of a layer of fluidic mass on a substratum, during continued distribution of fluidic mass, through changing a speed of a surface or changing a speed of a substratum, and stopping distribution of fluidic mass by stopping movement of the surface.

While the embodiments of the disclosed method and apparatus have been described with reference to exemplary embodiments, it will be understood by those skilled in the art that various changes may be made and equivalents may be substituted for elements thereof without departing from the scope of the embodiments of the disclosed method and apparatus. In addition, many modifications may be made to adapt a particular situation or material to the teachings of the embodiments of the disclosed method and apparatus without departing from the essential scope thereof. Therefore, it is intended that the embodiments of the disclosed method and apparatus not be limited to the particular embodiments disclosed as the best mode contemplated for carrying out the embodiments of the disclosed method and apparatus, but that the embodiments of the disclosed method and apparatus will include all embodiments falling within the scope of the appended claims.

Various aspects and embodiments of the present invention are defined by the following numbered clauses:
1. A system for distributing a fluidic mass, the system comprising:
   a receptacle receptive of the fluidic mass to be distributed;
   an opening, fluidically connected to the receptacle;
   a surface in operable communication with the opening and receptive of a distribution of the fluidic mass from the receptacle such that a rate of the distribution of the fluidic mass is determined by a speed of the surface relative to the opening and the surface and the receptacle are configured to prevent distribution of the fluidic mass when the surface is stationary with respect to the receptacle; and
   a substratum, positioned below the surface and movable relative to the surface, and movement of the substratum relative to the surface controls a thickness of a base layer of the fluidic mass formed on the substratum.
2. The system of clause 1, further comprising a blade, connected to the opening and positioned parallel to the surface and spaced from the surface to thereby control a thickness of an interim layer of the fluidic mass formed on the surface distributed from the receptacle as the surface moves.
3. The system of any preceding clause, wherein the blade is positioned relative to the surface such that head pressure in the receptacle is not able to force the fluidic mass between the surface and the blade..
4. The system of any preceding clause, further comprising at least one angled member positioned between the surface and the substratum such that the fluidic mass leaving the surface impinges upon at least one of the at least one angled member.
5. The system of any preceding clause, wherein the substratum is a setter plate in which wafer shaped recesses are formed, and wherein silicon powder is distributed for melting and re-crystallizing into wafers.
6. The system of any preceding clause, wherein the fluidic mass in the receptacle creates a seal between a controlled atmosphere on a surface side of the seal and a non-controlled atmosphere on a fluidic mass feeding side of the receptacle.
7. The system of any preceding clause, wherein the opening is below the receptacle such that gravity causes the fluidic mass to move from the receptacle and through the opening.
8. The system of any preceding clause, wherein the surface is on a cylinder.
9. The system of any preceding clause, wherein the surface of the cylinder is knurled.
10. The system of any preceding clause, wherein the surface is on a belt.
11. The system of any preceding clause, wherein the belt is guided by a plurality of cylinders.
12. The system of any preceding clause, wherein at least one of the plurality of cylinders is crowned.
13. A method of distributing a fluidic mass, comprising:
   disposing the fluidic mass in a receptacle with an opening;
   distributing the fluidic mass to a surface downstream of the opening;
   moving the surface thereby removing the fluidic mass from downstream of the opening to allow additional fluidic mass to distribute through the opening;
   controlling a rate of the distribution of the fluidic mass by a speed of the surface; and
   positioning the surface relative to the opening to prevent the fluidic mass from flowing through the opening when the surface is stationary.
14. The method of clause 13, further comprising positioning the surface relative to the opening such that a thickness of an interim layer of the fluidic mass on the surface is controlled by a distance between the surface and the opening.
15. The method of clause 13 or 14, further comprising positioning a substratum below the surface to receive a distribution of the fluidic mass from the surface.
16. The method of any of clauses 13 to 15, further comprising moving the substratum relative to the surface to control a thickness of a base layer of the fluidic mass thereon.
17. The method of any of clauses 13 to 16, further comprising adjusting the thickness of the base layer of the fluidic mass on the substratum without stopping the surface.
18. The method of any of clauses 13 to 17, further comprising adjusting the thickness of the base layer of the fluidic mass on the substratum by changing the speed of the surface.
19. The method of any of clauses 13 to 18, further comprising adjusting the thickness of the base layer of the fluidic mass on the substratum without changing a speed of the substratum.
20. The method of any of clauses 13 to 19, further comprising sealing an atmosphere in a furnace on a surface side of the opening from a fluidic mass feeding side of the opening with the fluidic mass.

## Claims

1. A system (10) for distributing a fluidic mass (18), the system (10) comprising:
a receptacle (14) receptive of the fluidic mass (18) to be distributed;
an opening (50), fluidically connected to the receptacle (14);
a surface (62) in operable communication with the opening (50) and receptive of a distribution of the fluidic mass (18) from the receptacle (14) such that a rate of the distribution of the fluidic mass (18) is determined by a speed of the surface (62) relative to the opening (50); and
a substratum (102), positioned below the surface (62) and movable relative to the surface (62), and movement of the substratum (102) relative to the surface (62) controls a thickness (106) of a base layer (110) of the fluidic mass (18) formed on the substratum (102).

2. The system (10) of claim 1, further comprising a blade (60), connected to the opening (50) and positioned parallel to the surface (62) and spaced from the surface (62) to thereby control a thickness (70) of an interim layer (68) of the fluidic mass (18) formed on the surface (62) distributed from the receptacle (14) as the surface (62) moves.

3. The system (10) of any preceding claim, wherein the fluidic mass (18) in the receptacle (14) creates a seal between a controlled atmosphere on a surface side of the seal and a non-controlled atmosphere on a fluidic mass feeding side of the receptacle (14).

4. The system (10) of any preceding claim, wherein the opening (50) is below the receptacle (14) such that gravity causes the fluidic mass (18) to move from the receptacle (14) and through the opening (50).

5. A method of distributing a fluidic mass (18), comprising:
disposing the fluidic mass (18) in a receptacle (14) with an opening (50);
distributing the fluidic mass (18) to a surface (62) downstream of the opening (50);
moving the surface (62) thereby removing the fluidic mass (18) from downstream of the opening (50) to allow additional fluidic mass (18) to distribute through the opening (50);
controlling a rate of the distribution of the fluidic mass (18) by a speed of the surface (62); and
positioning the surface (62) relative to the opening (50) to prevent the fluidic mass (18) from flowing through the opening (50) when the surface (62) is stationary.

6. The method of claim 5, further comprising positioning a substratum (102) below the surface (62) to receive a distribution of the fluidic mass (18) from the surface (62).

7. The method of claim 5 or 6, further comprising moving the substratum (102) relative to the surface (62) to control a thickness (106) of a base layer (110) of the fluidic mass (18) thereon.

8. The method of any of claims 5 to 7, further comprising adjusting the thickness (106) of the base layer (110) of the fluidic mass (18) on the substratum (102) without stopping the surface (62).

9. The method of any of claims 5 to 8, further comprising adjusting the thickness (106) of the base layer (68) of the fluidic mass (18) on the substratum (102) by changing the speed of the surface (62).

10. The method of any of claims 5 to 9, further comprising adjusting the thickness (106) of the base layer (110) of the fluidic mass (18) on the substratum (102) without changing a speed of the substratum (102).
